# EUROPEAN PATENT APPLICATION

(11) **EP 4 290 875 A1**
(43) Date of publication of application: **13.12.2023**
(21) Application number: 23701224.0
(22) Date of filing: 26.01.2023
(51) Int. Cl.: H04N 23/57, H04N 23/50, H04M 1/02, H05K 1/18

(54) **ELECTRONIC COMPONENT INCLUDING CONNECTOR, AND ELECTRONIC DEVICE COMPRISING SAME**

(30) Priority: 28.04.2022 KR 20220052561; 17.05.2022 KR 20220060219
(71) Applicant: Samsung Electronics Co., Ltd., Suwon-si, Gyeonggi-do 16677 (KR)
(72) Inventor: KIM, Doyun, Suwon-si, Gyeonggi-do 16677 (KR); KIM, Yongwoon, Suwon-si, Gyeonggi-do 16677 (KR); PARK, Eunsoo, Suwon-si, Gyeonggi-do 16677 (KR); JANG, Kyungsoo, Suwon-si, Gyeonggi-do 16677 (KR); AN, Jinwan, Suwon-si, Gyeonggi-do 16677 (KR); HAN, Yonggil, Suwon-si, Gyeonggi-do 16677 (KR)
(74) Representative: HGF
(86) International application number: PCT/KR2023/001195
(87) International publication number: WO 2023/210930

(57) **Abstract**

An electronic device includes a first printed circuit board, a first connector, a second printed circuit board including one surface of the second printed circuit board, and the other surface of the second printed circuit board, a second connector disposed on the one surface of the second printed circuit board, a stiffening member including a first coupling surface, and a supporting portion including a first seating surface in contact with at least part of the first coupling surface, the first coupling surface and the first seating surface respectively have a shape to guide the movement of the stiffening member with respect to the support portion so that the second connector moves toward the first connector, when the stiffening member moves in a direction parallel to the other surface of the second printed circuit board.

## Description

### [Technical Field]

The embodiments described below relate to an electronic component including a connector and an electronic device including the same.

### [Background Art]

An electronic device may include at least one electronic component to provide various functions to the user. For example, the electronic component may include a camera for obtaining an image by receiving light from the outside. The electronic component may be manufactured in a form of a module including a printed circuit board before being disposed in the electronic device. For example, the electronic component may be disposed in the electronic device through a connector that electrically connects the printed circuit board included in the electronic component and another printed circuit board of the electronic device.

### [Disclosure]

### [Technical Problem]

An electronic component included in an electronic device may perform a pre-designed function within the electronic device by being electrically connected to another printed circuit board by a connector connected to the other printed circuit board in the electronic device. When the connection between the printed circuit board of the electronic component and the other printed circuit board is disconnected during the assembly process, the electronic component may not perform the pre-designed function within the electronic device. When the connection of the connector is disconnected during the manufacturing process of the electronic device, since the electronic component must be disposed in the electronic device after the printed circuit board of the electronic component and the other printed circuit board are reconnected by the connector, the manufacturing process of the electronic device may be complicated, and the tact time may increase. The electronic device may need a method having a stable coupling structure of the connector.

The technical problems to be achieved in this document are not limited to those described above, and other technical problems not mentioned herein will be clearly understood by those having ordinary knowledge in the art to which the present disclosure belongs, from the following description.

### [Technical Solution]

According to an embodiment, an electronic device may include a printed circuit board According to an embodiment, an electronic device may include a first connector attached on one surface of the printed circuit board. According to an embodiment, an electronic device may include a flexible printed circuit board including a first surface facing the one surface of the printed circuit board and a second surface opposite to the first surface. According to an embodiment, the electronic device may include a second connector attached to the first surface and aligned with the first connector for electrical connection between the printed circuit board and the flexible printed circuit board. According to an embodiment, the electronic device may include a stiffening member attached to the second surface and arranged with respect to the second connector. According to an embodiment, the electronic device may include a supporting portion corresponding to the stiffening member. According to an embodiment, the stiffening member includes a first coupling surface inclined with respect to the first surface to which the second connector aligned with the first connector is attached. According to an embodiment, the supporting portion includes a first seating surface parallel to the first coupling surface and facing the first coupling surface for the alignment of the first connector and the second connector.

According to an embodiment, an electronic device may include a printed circuit board including a first connector. According to an embodiment, the electronic device may include a flexible printed circuit board including a first surface, a second surface opposite to the first surface, and a second connector disposed to the first surface, and the flexible printed circuit board electrically connected to the printed circuit board through the second connector coupled to the first connector. According to an embodiment, the electronic device may include a stiffening member disposed to the second surface. According to an embodiment, the electronic device may include a supporting portion facing the stiffening member, and having a shape corresponding to the stiffening member, configured to inhibit the first connector and the second connector from being separated each other. According to an embodiment, the stiffening member including a first coupling surface and the second coupling surfaced inclined with respect to the second surface respectively. According to an embodiment, the first coupling surface and the second coupling surface inclined with respect to a direction in which the second surface faces. According to an embodiment, the supporting portion includes a first seating surface parallel to the first coupling surface and facing the first coupling surface, and a second seating surface parallel to the second coupling surface and facing the second coupling surface.

According to an embodiment, an electronic device may include a first printed circuit board. a first connector disposed on one surface of the first printed circuit board. According to an embodiment, the electronic device may include a second printed circuit board including one surface of the second printed circuit board facing the one surface of the first printed circuit board, and the other surface of the second printed circuit board. According to an embodiment, the electronic device may include a second connector disposed on the one surface of the second printed circuit board. According to an embodiment, the electronic device may include a stiffening member including a first coupling surface and disposed on the other surface of the second printed circuit board. According to an embodiment, the electronic device may include a supporting portion including a first seating surface in contact with at least part of the first coupling surface and arranged to support the stiffening member. According to an embodiment, the first coupling surface and the first seating surface respectively have a shape to guide the movement of the stiffening member with respect to the support portion so that the second connector moves toward the first connector, when the stiffening member moves in a direction parallel to the other surface of the second printed circuit board.

### [Advantageous Effects]

An electronic component and an electronic device including the same according to an embodiment can provide a structure capable of preventing(or inhibiting) separation of a connector of the electronic component during a manufacturing process of the electronic device.

The effects that can be obtained from the present disclosure are not limited to those described above, and any other effects not mentioned herein will be clearly understood by those having ordinary knowledge in the art to which the present disclosure belongs, from the following description.

### [Description of the Drawings]

FIG. 1 is a block diagram of an electronic device in a network environment according to various embodiments.
FIG. 2 is a block diagram illustrating a camera module according to an embodiment.
FIG. 3A shows an example of an electronic device according to an embodiment.
FIG. 3B is a cross-sectional view illustrating an example of cutting an electronic device along A-A' of FIG. 3A according to an embodiment.
FIG. 4A is an exploded prospective view of an electronic component and a supporting portion according to an embodiment.
FIG. 4B is a rear view of a second region of an electronic component according to an embodiment.
FIG. 4c is a cross-sectional view illustrating an example of cutting an electronic component and a supporting portion along B-B' of FIG. 4A according to an embodiment.
FIG. 5 is a cross-sectional view of a second region and a supporting portion of an electronic component according to an embodiment.
FIG. 6A is a rear view of a second region of an electronic component according to an embodiment.
FIG. 6B is a cross-sectional view of a second region and a supporting portion of an electronic component according to an embodiment.
FIG. 7 is a cross-sectional view of a second region and a supporting portion of an electronic component according to an embodiment.
FIG. 8A is a rear view of a second region and a supporting portion of an electronic component according to an embodiment.
FIG. 8B is a cross-sectional view of a second region and a supporting portion of an electronic component according to an embodiment.

### [Mode for Invention]

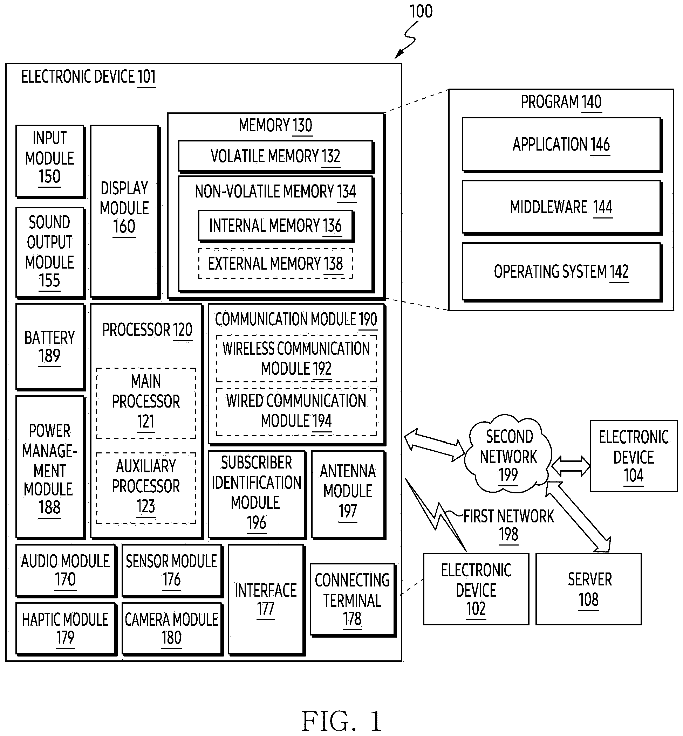

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

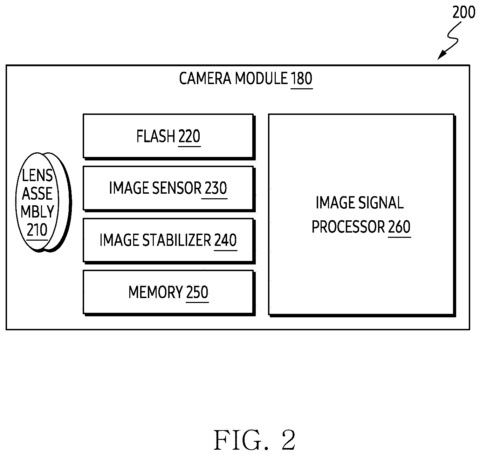

FIG. 2 is a block diagram 200 illustrating the camera module 180 according to various embodiments.

Referring to FIG. 2, the camera module 180 may include a lens assembly 210, a flash 220, an image sensor 230, an image stabilizer 240, memory 250 (e.g., buffer memory), or an image signal processor 260. The lens assembly 210 may collect light emitted or reflected from an object whose image is to be taken. The lens assembly 210 may include one or more lenses. According to an embodiment, the camera module 180 may include a plurality of lens assemblies 210. In such a case, the camera module 180 may form, for example, a dual camera, a 360-degree camera, or a spherical camera. Some of the plurality of lens assemblies 210 may have the same lens attribute (e.g., view angle, focal length, auto-focusing, f number, or optical zoom), or at least one lens assembly may have one or more lens attributes different from those of another lens assembly. The lens assembly 210 may include, for example, a wide-angle lens or a telephoto lens.

The flash 220 may emit light that is used to reinforce light reflected from an object. According to an embodiment, the flash 220 may include one or more light emitting diodes (LEDs) (e.g., a red-green-blue (RGB) LED, a white LED, an infrared (IR) LED, or an ultraviolet (UV) LED) or a xenon lamp. The image sensor 230 may obtain an image corresponding to an object by converting light emitted or reflected from the object and transmitted via the lens assembly 210 into an electrical signal. According to an embodiment, the image sensor 230 may include one selected from image sensors having different attributes, such as a RGB sensor, a black-and-white (BW) sensor, an IR sensor, or a UV sensor, a plurality of image sensors having the same attribute, or a plurality of image sensors having different attributes. Each image sensor included in the image sensor 230 may be implemented using, for example, a charged coupled device (CCD) sensor or a complementary metal oxide semiconductor (CMOS) sensor.

The image stabilizer 240 may move the image sensor 230 or at least one lens included in the lens assembly 210 in a particular direction, or control an operational attribute (e.g., adjust the read-out timing) of the image sensor 230 in response to the movement of the camera module 180 or the electronic device 101 including the camera module 180. This allows compensating for at least part of a negative effect (e.g., image blurring) by the movement on an image being captured. According to an embodiment, the image stabilizer 240 may sense such a movement by the camera module 180 or the electronic device 101 using a gyro sensor (not shown) or an acceleration sensor (not shown) disposed inside or outside the camera module 180. According to an embodiment, the image stabilizer 240 may be implemented, for example, as an optical image stabilizer. The memory 250 may store, at least temporarily, at least part of an image obtained via the image sensor 230 for a subsequent image processing task. For example, if image capturing is delayed due to shutter lag or multiple images are quickly captured, a raw image obtained (e.g., a Bayer-patterned image, a high-resolution image) may be stored in the memory 250, and its corresponding copy image (e.g., a low-resolution image) may be previewed via the display module 160. Thereafter, if a specified condition is met (e.g., by a user's input or system command), at least part of the raw image stored in the memory 250 may be obtained and processed, for example, by the image signal processor 260. According to an embodiment, the memory 250 may be configured as at least part of the memory 130 or as a separate memory that is operated independently from the memory 130.

The image signal processor 260 may perform one or more image processing with respect to an image obtained via the image sensor 230 or an image stored in the memory 250. The one or more image processing may include, for example, depth map generation, three-dimensional (3D) modeling, panorama generation, feature point extraction, image synthesizing, or image compensation (e.g., noise reduction, resolution adjustment, brightness adjustment, blurring, sharpening, or softening). Additionally or alternatively, the image signal processor 260 may perform control (e.g., exposure time control or read-out timing control) with respect to at least one (e.g., the image sensor 230) of the components included in the camera module 180. An image processed by the image signal processor 260 may be stored back in the memory 250 for further processing, or may be provided to an external component (e.g., the memory 130, the display module 160, the electronic device 102, the electronic device 104, or the server 108) outside the camera module 180. According to an embodiment, the image signal processor 260 may be configured as at least part of the processor 120, or as a separate processor that is operated independently from the processor 120. If the image signal processor 260 is configured as a separate processor from the processor 120, at least one image processed by the image signal processor 260 may be displayed, by the processor 120, via the display module 160 as it is or after being further processed.

According to an embodiment, the electronic device 101 may include a plurality of camera modules 180 having different attributes or functions. In such a case, at least one of the plurality of camera modules 180 may form, for example, a wide-angle camera and at least another of the plurality of camera modules 180 may form a telephoto camera. Similarly, at least one of the plurality of camera modules 180 may form, for example, a front camera and at least another of the plurality of camera modules180 may form a rear camera.

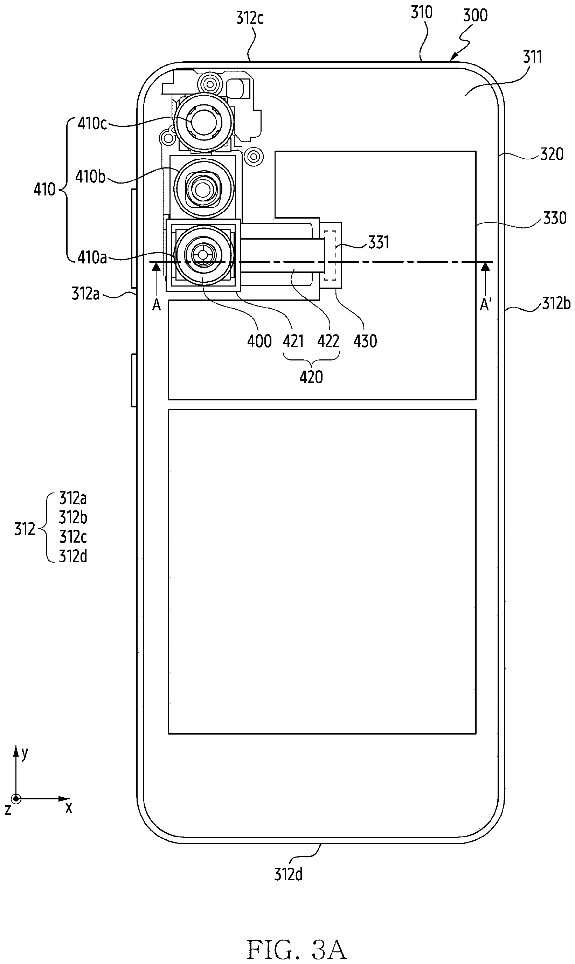

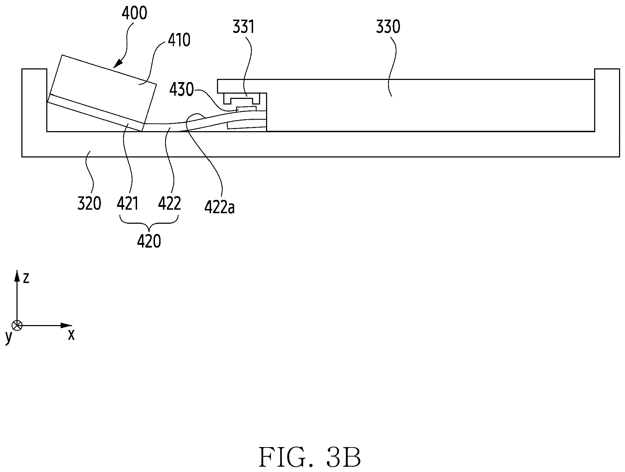

FIG. 3A shows an example of an electronic device according to an embodiment and FIG. 3B is a cross-sectional view illustrating an example of cutting an electronic device along A-A' of FIG. 3A according to an embodiment.

Referring to FIGS. 3A and 3B, an electronic device 300 (e.g., the electronic device 101 of FIG. 1) according to an embodiment may include a housing 310, a supporting portion 320, a first printed circuit board 330, and/or an electronic component or module 400 (e.g., the camera module 180 of FIG. 1 and/or the camera module 180 of FIG. 2). According to an embodiment, the supporting portion 320 may be refer to as a support member, a support structure, and/or a portion of the housing.

The housing 310 may form an overall exterior of the electronic device 300 and may form an internal space in which various components of the electronic device 300 are disposed. For example, when the electronic device 300 is gripped by the user, the housing 310 may form at least a part of an outer surface in contact with a part of the user's body. According to an embodiment, the housing 310 may include a front surface (not shown) on which a display (e.g., the display module 160 of FIG. 1) is disposed, a rear surface 311 facing the front surface, and a side surface 312 connecting a periphery of the front surface and a periphery of the rear surface 311. The front surface, the rear surface 311, and the side surface 312 of the housing 310 may form the internal space of the housing 310.

According to an embodiment, the side surface 312 may include a first side surface 312a extending in a first direction (e.g., the -y direction), a second side surface 312b spaced apart from the first side surface 312a and extending in the first direction to be parallel to the first side surface 312a, a third side surface 312c extending from one end of the first side surface 312a to one end of the second side surface 312b in a second direction (e.g., the +x direction) substantially perpendicular to the first direction, and a fourth side surface 312d extending from another end of the first side surface 312a to another end of the second side surface 312b along the second direction. For example, the first side surface 312a and the second side surface 312b may extend longer than the third side surface 312c and the fourth side surface 312d so that the electronic device 300 has a length.

The supporting portion 320 may support at least one component disposed in the electronic device 300. For example, the supporting portion 320 may include a recess or a hole for accommodating the component of the electronic device 300, but is not limited thereto. According to an embodiment, the supporting portion 320 may be disposed in the housing 310 and surrounded by the side surface 312 of the housing 310. The supporting portion 320 may surround the first printed circuit board 330 and the electronic component 400. In FIGS. 3A and 3B, the supporting portion 320 is illustrated as a component distinguished from the housing 310, but this is for convenience of description. According to embodiments, the supporting portion 320 may mean a part of the housing 310 that is integrally formed with the housing 310 and accommodates the component in the electronic device 300.

The first printed circuit board 330 may form an electrical connection between components of the electronic device 300 that perform the overall operation of the electronic device 300. For example, the first printed circuit board 330 may mean a main circuit board of the electronic device 300 on which a processor (e.g., the processor 120 of FIG. 1) is disposed. According to an embodiment, the first printed circuit board 330 may electrically connect electronic components disposed on the first printed circuit board 330 to each other. According to an embodiment, the first printed circuit board 330 may electrically connect the electronic component (e.g., the processor 120 of FIG. 1) disposed on the first printed circuit board 330 and the other electronic component (e.g., the electronic component 400) disposed outside the first printed circuit board 330. For example, the first printed circuit board 330 may be electrically connected to another electronic component disposed outside the first printed circuit board 330 by a connecting member. The connection member may include, for example, a coaxial cable connector, a board to board connector, an interposer, or a flexible printed circuit board (FPCB).

According to an embodiment, the first printed circuit board 330 may include a first connector 331. The first connector 331 may connect the first printed circuit board 330 to another printed circuit board in the electronic device 300. The first connector 331 may be disposed on one surface of the first printed circuit board 330. The first connector 331 may be attached on one surface of the first printed circuit board 330. The first connector 331 may be, for example, one of a socket connector and a plug connector of the board to board connector, but is not limited thereto. According to an embodiment, the first connector 331 may be spaced apart from the electronic component 400 in the second direction (e.g., the +x direction).

According to an embodiment, the electronic component 400 may be referred to as a camera module. However, it is not limited thereto. For example, the electronic component 400 may mean the component of the electronic device 300 that is distinguished from the camera module and includes a circuit and/or the printed circuit board configured to perform a designated function within the electronic device 300. The electronic component 400 may include, for example, at least one of at least one sensor, an antenna (e.g., the antenna module 197 of FIG. 1), or at least one processor (e.g., the processor 120 of FIG. 1). According to an embodiment, the electronic component 400 may be disposed in the housing 310. For example, the electronic component 400 may be surrounded by the supporting portion 320 in the housing 310. According to an embodiment, the electronic component 400 may face the rear surface 311 of the housing 310 of the electronic device 300, and at least a part thereof may be visible through the rear surface 311 of the housing 310, but is not limited thereto. The electronic component 400 may face the front surface of the housing 310 of the electronic device 300, and at least a part thereof may be visible through the front surface of the housing 310. According to an embodiment, the electronic component 400 may be spaced apart from the first printed circuit board 330 in a direction (e.g., the -x direction) opposite to the second direction. For example, the electronic component 400 may be spaced apart from the first printed circuit board 330 and may be close to the first side surface 312a among the first side surface 312a and the second side surface 312b.

According to an embodiment, the electronic component 400 may include at least one body 410, a second printed circuit board 420, and/or a second connector 430. According to an embodiment, the body 410 may include a camera that obtains an image based on receiving light emitted from an external subject of the electronic device 300, but is not limited thereto. For example, the body 410 of the electronic component may include a circuitry configured to perform a designated function within the electronic device 300. The body 410 may be disposed on the second printed circuit board 420 of the electronic component 400. According to an embodiment, at least one body 410 may include a plurality of cameras 410a, 410b, and 410c. The plurality of cameras 410a, 410b, and 410c may perform different functions from each other. For example, the plurality of cameras 410a, 410b, and 410c may be at least one of a depth camera, a wide-angle camera, an ultra-wide-angle camera, and a telephoto camera, but are not limited thereto. According to embodiments, the plurality of cameras 410a, 410b, and 410c may perform the same function as each other.

The second printed circuit board 420 may form an electrical connection between components (e.g., the body 410) in the electronic component 400. The second printed circuit board 420 may form an electrical connection between the component in the electronic component 400 and the first printed circuit board 330. For example, the second printed circuit board 420 may provide a power supply signal for supplying power transmitted from the first printed circuit board 330 to the body 410, or a path through which a control signal for controlling the operation of the body 410 may move. According to an embodiment, the second printed circuit board 420 may include a first region 421 and a second region 422. The first region 421 may support the body 410. According to an embodiment, as the first region 421 has rigidity, it may not be deformed by an external force. The second region 422 may extend from the first region 421. For example, the second region 422 may extend from a periphery of the first region 421 facing the second direction (e.g., the +x direction). According to an embodiment, at least a part of the second region 422 may not have rigidity, unlike the first region 421, but may have flexibility. As at least a part of the second region 422 does not have rigidity, at least a part of the second region 422 may be deformable by an external force. According to an embodiment, the second region 422 may electrically connect the first printed circuit board 330 and the first region 421. For example, the second region 422 may be referred to as a cable for electrically connecting the electronic component 400 and the first printed circuit board 330. According to an embodiment, the first region 421 and the second region 422 may form a rigid flexible printed circuit board (RFPCB) together.

The second connector 430 may be coupled to the first connector 331 to connect the second printed circuit board 420 and the first printed circuit board 330 of the electronic component 400. According to an embodiment, the second connector 430 may have a shape corresponding to the shape of the first connector 331, and at least a part thereof may be inserted into the first connector 331. For example, the second connector 430 may be one of a socket connector and a plug connector of a board-to-board connector. According to an embodiment, the second connector 430 may be spaced apart from the first region 421. The second connector 430 may be disposed on one surface 422a of the second region 422 spaced apart from the first region 421 in the second direction (e.g., the +x direction). The second connector 430 may be attached on one surface 422a of the second region 422. According to an embodiment, the second connector 430 may be aligned with the first connector 430 for electrical connection between the first printed circuit board 330 and the second printed circuit board 420. For example, one surface 422a of the second region 422 may face one surface of the first printed circuit board 330 on which the first connector 331 is disposed.

According to an embodiment, when the electronic component 400 is assembled to the electronic device 300, the second connector 430 of the electronic component 400 may be separated from the first connector 331 of the first printed circuit board 330 due to stress generated during assembly of the electronic component 400. For example, the electronic component 400 and the first printed circuit board 330 may be accommodated in the supporting portion 320 in a state of being connected by the first connector 331 and the second connector 430. The first region 421 of the electronic component 400 may be inclined with respect to the second region 422 by the external force acting on the electronic component 400 when the electronic component 400 is assembled to the supporting portion 320. The stress generated as the first region 421 is inclined may transmitted to the second connector 430 through the second region 422 to separate the second connector 430 and the first connector 331. For another example, when the electronic component 400 and the first printed circuit board 330 are disposed in the electronic device 300, the first printed circuit board 330 may be disposed on the supporting portion 320 after the electronic component 400 is disposed on the supporting portion 320. When the first printed circuit board 330 is disposed on the supporting portion 320 after the electronic component 400 is disposed on the supporting portion 320, the second region 422 may be bent due to the external force for coupling the first connector 331 and the second connector 430. The stress generated by the bending of the second region 422 may be transmitted to the second connector 430 to separate the second connector 430 and the first connector 331. When the first connector 331 and the second connector 430 are disconnected during the assembly process of the electronic component 400, the electronic component 400 may not perform a pre-designed function or a manufacturing process of the electronic device 300 may be complicated. Hereinafter, the electronic component 400 including a structure for preventing separation of the first connector 331 of the first printed circuit board 330 and the second connector 430 of the electronic component 400 in the assembly process of the electronic component 400 will be described.

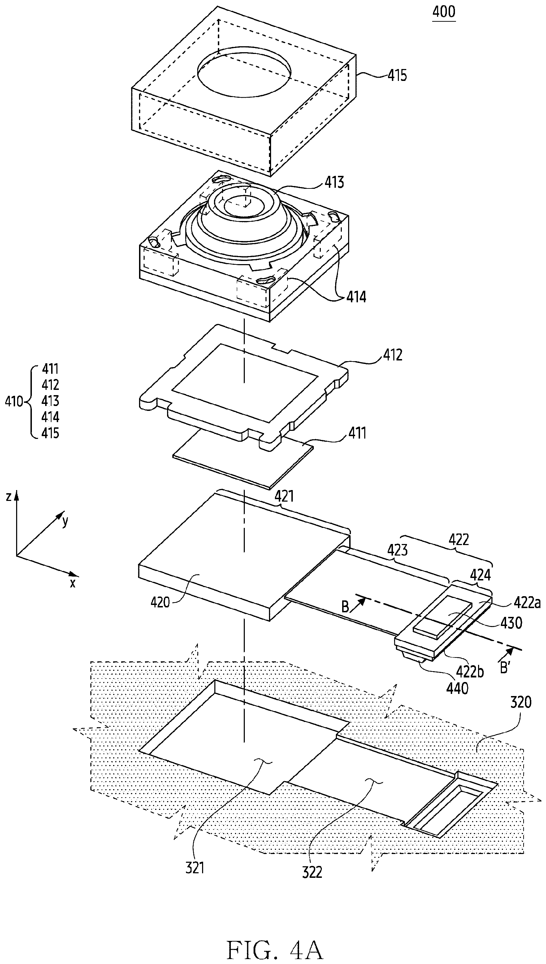

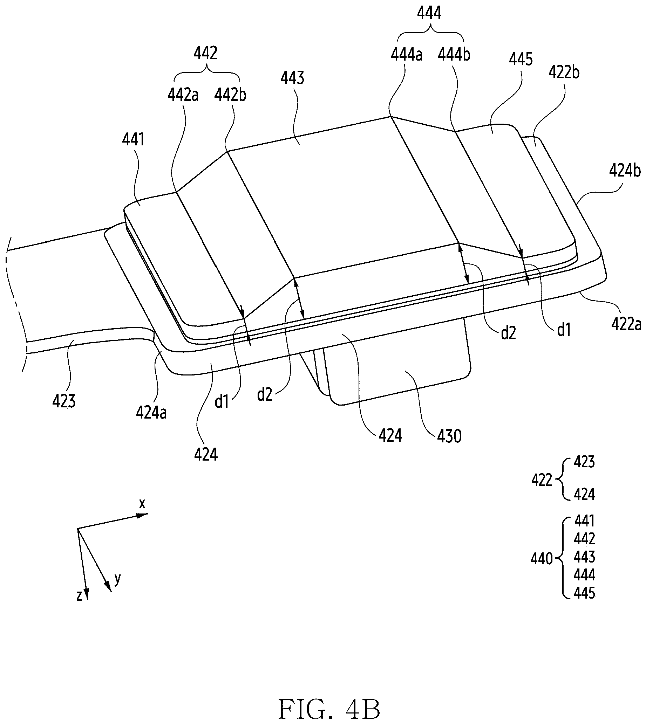

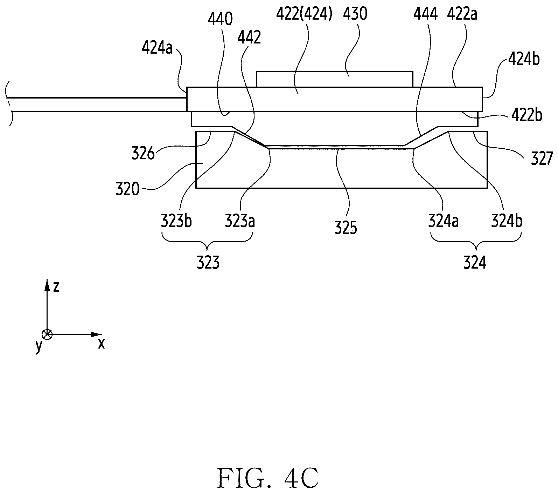

FIG. 4A is an exploded prospective view of an electronic component and a supporting portion according to an embodiment, FIG. 4B is a rear view of a second region of an electronic component according to an embodiment, and FIG. 4c is a cross-sectional view illustrating an example of cutting an electronic component and a supporting portion along B-B' of FIG. 4A according to an embodiment.

Referring to FIGS. 4A, 4B, and 4C, the body 410 of the electronic component 400 according to an embodiment may include an image sensor 411, an optical filter 412, a lens assembly 413, an actuator 414, and/or a shield can 415.

The image sensor 411 may obtain an electrical signal for obtaining an image based on receiving light from the lens assembly 413. According to an embodiment, the image sensor 411 may be disposed on the first region 421 of the second printed circuit board 420. For example, the image sensor 411 may include a charge coupled device (CCD) or a complementary metal oxide semiconductor (CMOS).

The optical filter 412 may selectively filter light having a specific wavelength. The light filtered by the optical filter 412 may be transmitted to the image sensor 411. For example, the optical filter 412 may be an infrared filter that filters infrared rays that cause chromatic aberration and/or a decrease in resolution, but is not limited thereto. According to an embodiment, the optical filter 412 may be disposed on the image sensor 411. For example, the optical filter 412 may be disposed between the image sensor 411 and the lens assembly 413.

The lens assembly 413 may collect light emitted from an external subject of the electronic device (e.g., the electronic device 300 of FIG. 3A). According to an embodiment, the lens assembly 413 may be movable with respect to the second printed circuit board 420. For example, the lens assembly 413 may move along an optical axis direction (e.g., the +z direction or the -z direction) of the camera of the electronic component 400. For another example, the lens assembly 413 may move along a direction (e.g., +x direction, -x direction, +y direction, or -y direction) perpendicular to the optical axis direction on the second printed circuit board 420. When the lens assembly 413 moves in a direction perpendicular to the optical axis direction, the moving direction of the lens assembly 413 may be parallel to the first region 421 of the second printed circuit board 420 on the second printed circuit board 420.

The actuator 414 may provide a driving force to the lens assembly 413 so that the lens assembly 413 may be movable. According to an embodiment, the actuator 414 may move the lens assembly 413 in the optical axis direction of the electronic component 400 for auto-focusing. As the lens assembly 413 moves in the optical axis direction of the electronic component 400, the distance between the lens assembly 413 and the image sensor 411 may be changed. The actuator 414 may adjust the focal length of the electronic component 400 based on changing the distance between the lens assembly 413 and the image sensor 411. For example, the actuator 414 may include at least one coil for providing driving force to lens assembly 413 or a magnet interacting with the at least one coil, but is not limited thereto.

The shield can 415 may shield electromagnetic waves penetrating into the electronic component 400 or electromagnetic waves emitted from the actuator 414. According to an embodiment, the shield can 415 may surround at least a part of the lens assembly 413. According to an embodiment, the shield can 415 may be electrically connected to a ground of the second printed circuit board 420 to shield electromagnetic waves transmitted to the electronic component 400. The shield can 415 may include, for example, a metal material such as copper or aluminum, or a composite material in which a metal material and a filler (e.g., polymer material such as carbon fiber, carbon black, carbon nanotube (CNT), or nickel coated graphite) are mixed.

According to an embodiment, the second region 422 of the second printed circuit board 420 may be connected to the first region 421. For example, the second region 422 may include a flexible region 423 extending from the first region 421 and a rigid region 424 spaced apart from the first region 421 and connected to the flexible region 423. The flexible region 423 may have flexibility and may be deformable by an external force. For example, the flexible region 423 may be referred to as a flexible printed circuit board. The rigid region 424 may have rigidity and may not be deformable by the external force. Alternatively, the third region 424 may also be flexible in isolation, but stiffened by a first member (or stiffening member) 440. According to an embodiment, the rigid region 424 may form a part of one surface 422a of the second region 422 and a part of the other surface 422b facing the one surface 422a of the second region 422. The other surface 422b of the second region 422 may be opposite to one surface of the second region 422a. For example, the direction in which the other surface 422b of the second region 422 faces (e.g., the -z direction) may be opposite to the direction in which the one surface 422a of the second region 422 faces (e.g., the +z direction). For example, the other surface 422b of the second region 422 may be parallel to the one surface 422a of the second region 422. According to an embodiment, the second connector 430 of the electronic component 400 may be disposed on the rigid region 424. For example, the second connector 430 may be disposed on the one surface 422a of the second region 422. However, it is not limited thereto, and according to embodiments, the rigid region 424 may be omitted from the second printed circuit board 420, and the second connector 430 may be disposed in the flexible region 423.

According to an embodiment, the electronic component 400 may further include a stiffening member 440. The stiffening member 440 may support the second region 422 and stiffen the rigidity of the rigid region 424 where the second connector 430 is disposed. The stiffening member 440 may be referred to as a stiffener, for example. According to an embodiment, the stiffening member 440 may be arranged with respect to the second connector 430. The stiffening member 440 may be disposed in the second region 422 of the second printed circuit board 420 where the second connector 430 is disposed. For example, the stiffening member 440 may be disposed on the rigid region 424 of the second printed circuit board 420. For another example, the stiffening member 440 may be disposed on the other surface 422b of the second region 422 facing the one surface 422a of the second region 422 in which the second connector 430 is disposed. The stiffening member 440 may include, for example, a conductive material, but is not limited thereto. According to an embodiment, the stiffening member 440 may be an integrally formed structure, but is not limited thereto. For example, the stiffening member 440 may be a structure formed by connecting a plurality of plates to each other. According to an embodiment, the stiffening member 440 may correspond to the supporting portion 320. For example, the stiffening member 440 may have a shape corresponding to the supporting portion 320.

According to an embodiment, the stiffening member 440 may include a first contacting surface 441, a first coupling surface 442, a connecting surface 443, a second coupling surface 444, and/or a second contacting surface 445. According to an embodiment, the first contacting surface 441, the first coupling surface 442, the connecting surface 443, the second coupling surface 444, and the second contacting surface 445 may be spaced apart from the other surface 422b of the second region 422. For example, the first contacting surface 441, the first coupling surface 442, the connecting surface 443, the second coupling surface 444, and/or the second contacting surface 445 may be spaced from the other surface 422b of the second region 422 in a direction (e.g., -z direction) in which the other surface 422b of the second region 422 faces.

The first contacting surface 441 may be parallel to the other surface 422b of the second region 422. According to an embodiment, the first contacting surface 441 may be disposed close to the first periphery 424a among the first periphery 424a of the rigid region 424 facing the first region 421 and the second periphery 424b facing the first periphery 424a.

The first coupling surface 442 may have a shape to guide the movement of the stiffening member 440 with respect to the supporting portion 320, when the stiffening member 440 moves in a direction parallel to the other surface 422b of the second region 422(e.g., +x, -x, +y, and/or - y direction). For example, the first coupling surface 442 may have a shape guide to guide the movement of the stiffening member 440 with respect to the supporting portion 320, so that the second connector 430 moves toward the first connector (e.g., +z direction) when the reinforcing member 440 moves in a direction parallel to the other surface 422b of the second region 422(e.g., +x, -x, +y, and/or -y direction). The first coupling surface 442 may be inclined with respect to the other surface 422b of the second region 422. The first coupling surface 442 may be inclined with respect to one surface 422a of the second region 422. According to an embodiment, the first coupling surface 442 may have a slope with respect to the other surface 422b of the second region 422. For example, an angle of the slope of the first coupling surface 442 with respect to the other surface 422b of the second region 422 may be greater than about 0 degrees to less than 90 degrees. However, it is not limited thereto. For example, the first coupling surface 442 is described as having an inclined surface shape, but the first coupling surface 442 may be curved with respect to the other surface 422b of the second region 422 to guide the movement of the stiffening member 440 with respect to the support 320. According to an embodiment, the one end 442a of the first coupling surface 442 facing the first region 421 may be spaced apart from the other surface 422b of the second region 422 by a first distance d1. The one end 442a of the first coupling surface 442 may be connected to the first contacting surface 441 and may mean a part of the first coupling surface 442 facing the first periphery 424a of the rigid region 424. According to an embodiment, the other end 442b of the first coupling surface 442 facing the one end 442a of the first coupling surface 442 may be spaced apart from the other surface 422b of the second region 422 by a second distance d2 distinct from the first distance d1. The other end 442b of the first coupling surface 442 may be connected to the connecting surface 443 and may mean another part of the first coupling surface 442 facing the second periphery 424b of the rigid region 424.

According to an embodiment, the first coupling surface 442 may extend from the one end 442a of the first coupling surface 442 to the other end 442b of the first coupling surface 442 in a direction away from the other surface 422b of the second region 422. As the first coupling surface 442 extends in the direction away from the other surface 422b of the second region 422, the first distance d1 between the one end 442a of the first coupling surface 442 and the other surface 422b of the second region 422 may be shorter than the second distance d2 between the other end 442b of the first coupling surface 442 and the other surface 422b of the second region 422.

The connecting surface 443 may be parallel to the other surface 422b of the second region 422. According to an embodiment, the connecting surface 443 may be disposed between the first coupling surface 442 and the second coupling surface 444. For example, the connecting surface 443 may be disposed between the other end 442b of the first coupling surface 442 and one end 444a of the second coupling surface 444 facing the first region 421. For another example, the connecting surface 443 may be connected to the other end 442b of the first coupling surface 442 and the one end 444a of the second coupling surface 444.

The second coupling surface 444 may have a shape to guide the movement of the stiffening member 440 with respect to the supporting portion 320 when the stiffening member 440 moves in a direction parallel to the other surface 422b of the second region 422(e.g., +x, -x, +y, and/or -y direction). For example, The second coupling surface 444 may have a shape guide to guide the movement of the stiffening member 440 with respect to the supporting portion 320, so that the second connector 430 moves toward the first connector (e.g., +z direction) when the reinforcing member 440 moves in a direction parallel to the other surface 422b of the second region 422(e.g., +x, -x, +y, and/or -y direction). The second coupling surface 444 may be inclined with respect to the other surface 422b of the second region 422. The second coupling surface 444 may be inclined with respect to one surface 422a of the second region 422. The second coupling surface 444 may be inclined with respect to the first coupling surface 442. According to an embodiment, the second coupling surface 444 may have a slope with respect to the other surface 422b of the second region 422. For example, the angle of the slope of the second coupling surface 444 with respect to the other surface 422b of the second region 422 may be greater than about 0 degrees to less than 90 degrees. However, it is not limited thereto. For example, the second coupling surface 444 is described as having an inclined surface shape, but the second coupling surface 444 may be curved with respect to the other surface 422b of the second region 422 to guide the movement of the stiffening member 440 with respect to the support 320. According to an embodiment, the one end 444a of the second coupling surface 444 facing the first region 421 may be spaced apart from the other surface 422b of the second region 422 by the second distance d2. The one end 444a of the second coupling surface 444 may be connected to the connecting surface 443 and may mean a part of the second coupling surface 444 facing the first periphery 424a of the rigid region 424. The one end 444a of the second coupling surface 444 may be spaced apart from the other end 442b of the first coupling surface 442. One end 440a of the second coupling surface 444 may be close to the other end 442b of the first coupling surface 442a among one end 442a of the first coupling surface 442 and the other end 442b of the first coupling surface 442. For example, a distance between one end 440a of the second coupling surface 444 and one end 442a of the first coupling surface 442 may be greater than a distance between one end 440a of the second coupling surface 444 and the other end 442b of the first coupling surface 442a. According to an embodiment, the other end 444b of the second coupling surface 444 facing the one end 444a of the second coupling surface 444 may be spaced apart from the other surface 422b of the second region 422 by the first distance d1. The other end 444b of the second coupling surface 444 may be connected to the second contacting surface 445 and may mean another part of the second coupling surface 444 facing the second periphery 424b of the rigid region 424.

According to an embodiment, the second coupling surface 444 may extend from the one end 444a of the second coupling surface 444 to the other end 444b of the second coupling surface 444 in a direction closer to the other surface 422b of the second region 422. As the second coupling surface 444 extends in a direction closer to the other surface 422b of the second region 422, the second distance d2 between the one end 444a of the second coupling surface 444 and the other surface 422b of the second region 422 may be longer than the first distance d1, which is the distance between the other end 444b of the second coupling surface 444 and the other surface 422b of the second region 422.

According to an embodiment, the first coupling surface 442 and the second coupling surface 444 may be symmetrical to each other. For example, the first coupling surface 442 and the second coupling surface 444 may be symmetrical with respect to the connecting surface 443. However, it is not limited thereto, and the deployment relationship of the first coupling surface 442 and the second coupling surface 444 may be changed in response to the magnitude of the external force acting on the first coupling surface 442 and the second coupling surface 444, respectively, when assembling the electronic component 400 and the first printed circuit board (e.g., the first printed circuit board 330 of FIGS. 3A and 3B). For example, when assembling the electronic component 400 and the first printed circuit board 330, when the magnitude of the external forces acting on the first coupling surface 442 and the second coupling surface 444, respectively, are different from each other, the first coupling surface 442 and the second coupling surface 444 may be asymmetrical.

According to an embodiment, when the second region 422 is viewed from above (e.g., in the -z direction or the +z direction), at least one of the first coupling surface 442 and the second coupling surface 444 may overlap the second connector 430 with at least a part thereof. For example, at least a part of the first coupling surface 442 may overlap with the second connector 430 when the second region 422 is viewed from above. For another example, at least a part of the second coupling surface 444 may overlap with the second connector 430 when the second region 422 is viewed from above.

The second contacting surface 445 may be parallel to the other surface 422b of the second region 422. According to an embodiment, the second contacting surface 445 may be connected to the other end 444b of the second coupling surface 444. The second contacting surface 445 may be disposed close to the second periphery 424b among the first periphery 424a and the second periphery 424b of the rigid region 424.

According to an embodiment, the distance between the connecting surface 443 and the other surface 422b of the second region 422 may be longer than the distance between the other surface 422b of the second region 422 from at least one of the first contacting surface 441 and the second contacting surface 445. For example, the distance between the connecting surface 443 and the other surface 422b of the second region 422 may be the second distance d2, and the distance between the other surface 422b of the second region 422 from the first contacting surface 441 and the second contacting surface 445 may be the first distance d1 shorter than the second distance d2.

According to an embodiment, the supporting portion 320 may accommodate at least a part of the electronic component 400 and may support at least a part of the electronic component 400. For example, at least a part of the electronic component 400 may be inserted into the supporting portion 320. According to an embodiment, the supporting portion 320 may include a first recess 321, a second recess 322, a first seating surface 323, a second seating surface 324, an extending surface 325, a first accommodating surface 326, and a second accommodating surface 327.

The first recess 321 may accommodate the first region 421 of the second printed circuit board 420. According to an embodiment, the first recess 321 may be formed by recessing a part of the supporting portion 320 inward (e.g., in the -z direction) of the supporting portion320. For example, the first recess 321 may have a shape corresponding to the first region 421.

The second recess 322 may accommodate the second region 422 of the second printed circuit board 420. According to an embodiment, the second recess 322 may be formed by recessing a part of the supporting portion 320 inward (e.g., in the -z direction) of the supporting portion 320. For example, the second recess 322 may have a shape corresponding to the second region 422.

The first seating surface 323 may have a shape to guide the movement of the stiffening member 440 with respect to the supporting portion 320, when the stiffening member 440 moves in a direction parallel to the other surface 422b of the second region 422(e.g., +x, -x, +y, and/or - y direction). For example, the first seating surface 323 may have a shape guide to guide the movement of the stiffening member 440 with respect to the supporting portion 320, so that the second connector 430 moves toward the first connector (e.g., +z direction) when the reinforcing member 440 moves in a direction parallel to the other surface 422b of the second region 422(e.g., +x, -x, +y, and/or -y direction). For example, the first seating surface 323 may have a shape for applying force to the stiffening member 440 so that the second connector 430 moves toward the first connector (e.g., +z direction) when the reinforcing member 440 receives a force a direction parallel to the other surface 422b of the second region 422(e.g., +x, -x, +y, and/or -y direction). The first seating surface 323 may be in contact with at least a part of the first coupling surface 442 of the stiffening member 440 when the electronic component 400 is accommodated in the supporting portion 320. According to an embodiment, the first seating surface 323 may face the first coupling surface 442 and may be parallel to the first coupling surface 442. For example, the first seating surface 323 may be inclined with respect to the other surface 422b of the second region 422. For another example, the slope of the first seating surface 323 with respect to the other surface 422b of the second region 422 may be substantially the same as the slope of the first coupling surface 442 with respect to the other surface 422b of the second region 422. For example, the first seating surface 323 may be inclined with respect to the coupling direction of the first connector 331 and the second connector 430. According to an embodiment, the distance between the first seating surface 323 and the other surface 422b of the second region 422 may increase as the first seating surface 323 extends in a direction (e.g., +x direction) from the first periphery 424a toward the second periphery 424b. However, it is not limited thereto. For example, the first seating surface 323 may be curved with respect to the other surface 422b of the second region 422. According to an embodiment, at least a part of the first seating surface 323 may overlap the second connector 430 when the second printed circuit board 420 is viewed from above.

The second seating surface 324 may have a shape to guide the movement of the stiffening member 440 with respect to the supporting portion 320, when the stiffening member 440 moves in a direction parallel to the other surface 422b of the second region 422(e.g., +x, -x, +y, and/or -y direction). For example, the second seating surface 324 may have a shape guide to guide the movement of the stiffening member 440 with respect to the supporting portion 320, so that the second connector 430 moves toward the first connector (e.g., +z direction) when the reinforcing member 440 moves in a direction parallel to the other surface 422b of the second region 422(e.g., +x, -x, +y, and/or -y direction). For example, the second seating surface 324 may have a shape for applying force to the stiffening member 440 so that the second connector 430 moves toward the first connector (e.g., +z direction) when the reinforcing member 440 receives a force a direction parallel to the other surface 422b of the second region 422(e.g., +x, -x, +y, and/or -y direction). The second seating surface 324 may be in contact with at least a part of the second coupling surface 444 of the stiffening member 440 when the electronic component 400 is accommodated in the supporting portion 320. The second seating surface 324 may be inclined with respect to the first seating surface 323. According to an embodiment, the second seating surface 324 may be spaced apart from the first seating surface 323. The second seating surface 324 may face the second coupling surface 444 and may be parallel to the second coupling surface 444. For example, the second seating surface 324 may be inclined with respect to the other surface 422b of the second region 422. For another example, the slope of the second seating surface 324 with respect to the other surface 422b of the second region 422 may be substantially the same as the slope of the second coupling surface 444 with respect to the other surface 422b of the second region 422. For example, the first seating surface 323 may be inclined with respect to the coupling direction of the first connector 331 and the second connector 430. However, it is not limited thereto. For example, the second seating surface 324 may be curved with respect to the other surface 422b of the second region 422. According to an embodiment, at least a part of the second seating surface 324 may overlap the second connector 430 when the second printed circuit board 420 is viewed from above.

According to an embodiment, the distance between the second seating surface 324 and the other surface 422b of the second region 422 may decrease as the second seating surface 324 extends in a direction (e.g., the +x direction) from the first periphery 424a toward the second periphery 424b.

According to an embodiment, when the second region 422 is viewed from above (e.g., in the +z direction or the -z direction), the first seating surface 323 and the second seating surface 324 may overlap at least a part of the first coupling surface 442 and at least a part of the second coupling surface 444, respectively. For example, when the second region 422 is viewed from above, the first seating surface 323 may overlap at least a part of the first coupling surface 442. For another example, when the second region 422 is viewed from above, the second seating surface 324 may overlap at least a part of the second coupling surface 444.

The extending surface 325 may be in contact with at least a part of the connecting surface 443 of the stiffening member 440 when the electronic component 400 is accommodated in the supporting portion 320. According to an embodiment, the extending surface 325 may be parallel to the other surface 422b of the second region 422. According to an embodiment, the extending surface 325 may be disposed between the first seating surface 323 and the second seating surface 324. For example, the extending surface 325 may be disposed between one end 323a of the first seating surface 323 and one end 324a of the second seating surface 324. The one end 323a of the first seating surface 323 may mean a part of the first seating surface 323 facing the second periphery 424b of the rigid region 424. The one end 324a of the second seating surface 324 may mean a part of the second seating surface 324 facing the first periphery 424a of the rigid region 424.

The first accommodating surface 326 may be in contact with at least a part of the first contacting surface 441 of the stiffening member 440 when the electronic component 400 is accommodated in the supporting portion 320. According to an embodiment, the first accommodating surface 326 may be connected to the other end 323b of the first seating surface 323 facing the one end 323a of the first seating surface 323 connected to the extending surface 325. The first accommodating surface 326 may be parallel to the other surface 422b of the second region 422.

The second accommodating surface 327 may be in contact with at least a part of the second contacting surface 445 of the stiffening member 440 when the electronic component 400 is accommodated in the supporting portion 320. According to an embodiment, the second accommodating surface 327 may be connected to the other end 324b of the second seating surface 324 facing the one end 324a of the second seating surface 324 in contact with the extending surface 325. The second accommodating surface 327 may be parallel to the other surface 422b of the second region 422.

According to an embodiment, the distance between the other surface 422b of the second region 422 from the extending surface 325 may be longer than the distance between the other surface 422b of the second region 422 from at least one of the first accommodating surface 326 and the second accommodating surface 327. For example, the distance between the extending surface 325 and the other surface 422b of the second region 422 may be longer than the distance between the first accommodating surface 326 and the other surface 422b of the second region 422. For another example, the distance between the extending surface 325 and the other surface 422b of the second region 422 may be longer than the distance between the second accommodating surface 327 and the other surface 422b of the second region 422. According to an embodiment, the distance between the first accommodating surface 326 and the other surface 422b of the second region 422 may be substantially the same as the distance between the second accommodating surface 327 and the other surface 422b of the second region 422.

According to an embodiment, at least one of the first coupling surface 442 and the second coupling surface 444 may be inclined with respect to a direction (e.g., the -z direction or the +z direction) in which the first connector (e.g., the first connector 331 of FIG. 3A) and the second connector 430 are coupled. For example, the first connector 331 and the second connector 430 may be coupled to each other after the electronic component 400 is disposed on the supporting portion 320. When coupling the first connector 331 and the second connector 430, the second region 422 may receive an external force in a direction (e.g., in the -x direction or the +x direction) perpendicular to the coupling direction of the first connector 331 and the second connector 430. When the second region 422 is bent by the external force, stress may be generated at the first periphery 424a of the rigid region 424. When the stiffening member 440 does not include the first coupling surface 442 and the second coupling surface 444, the stress generated by bending the second region 422 may separate the second connector 430 from the first connector 331. The electronic component 400 according to an embodiment may provide a structure capable of preventing separation of the second connector 430 by the first coupling surface 442 and the second coupling surface 444 inclined with respect to the coupling direction of the first connector 331 and the second connector 430. For example, when the second region 422 receives the external force in a direction (e.g., the -x direction) perpendicular to the coupling direction of the first connector 331 and the second connector 430, the first coupling surface 442 may slide with respect to the first seating surface 323 by the external force. The second connector 430 may move in the coupling direction (e.g., the +z direction) of the second connector 430 by the movement of the first coupling surface 442. For another example, when the second region 422 receives the external force in a direction (e.g., the +x direction) perpendicular to the coupling direction of the first connector 331 and the second connector 430, the second coupling surface 444 may slide with respect to the second seating surface 324 by the external force. The second connector 430 may move in the coupling direction (e.g., the +z direction) of the second connector 430 by the movement of the second coupling surface 444. As the second connector 430 moves in the coupling direction of the second connector 430, the separation of the second connector 430 and the first connector 331 may be prevented.

As described above, the electronic component 400 and the electronic device 300 including the same according to an embodiment may provide a structure capable of preventing separation of the first connector 331 and the second connector 430 by the first coupling surface 442 and the second coupling surface 444 inclined with respect to the other surface 422b of the second region 422.

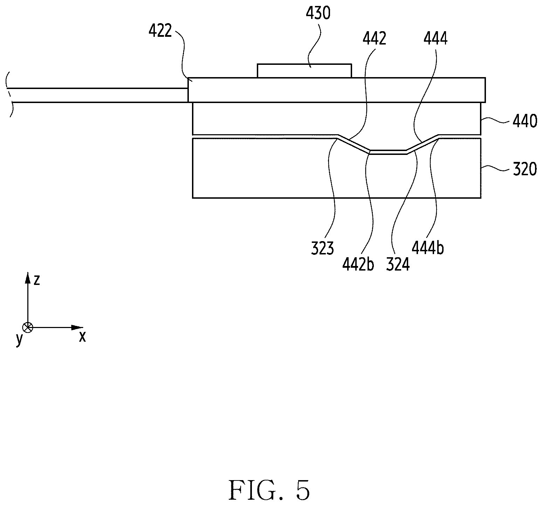

FIG. 5 is a cross-sectional view of a second region and a supporting portion of an electronic component according to an embodiment.

The supporting portion 320 and the stiffening member 440 in FIG. 5 may be the supporting portion 320 and the stiffening member 440 in which the structures of the supporting portion 320 and the stiffening member 440 in FIGS. 4A, 4B, and/or 4C are changed, respectively, and overlapping descriptions will be omitted.

Referring to FIG. 5, according to an embodiment, when the second region 422 is viewed from above, at least one of the first coupling surface 442 and the second coupling surface 444 may be at least partially spaced apart from the second connector 430. For example, another end 442b of the first coupling surface 442 may be spaced apart from the second connector 430 when the second region 422 is viewed from above. For another example, another end 444b of the second coupling surface 444 may be spaced apart from the second connector 430 when the second region 422 is viewed from above.

According to an embodiment, when the second region 422 is viewed from above, at least one of the first seating surface 323 and the second seating surface 324 may be at least partially spaced apart from the second connector 430. For example, the position of the first seating surface 323 may correspond to the position of the first coupling surface 442, and the position of the second seating surface 324 may correspond to the position of the second coupling surface 444.

In FIG. 5, when the second region 422 is viewed from above, a part of the first coupling surface 442 and a part of the second coupling surface 444 are illustrated as overlapping the second connector 430, but this is for convenience of description. According to embodiments, when the second region 422 is viewed from above, the first coupling surface 442 and the second coupling surface 444 may not overlap with the second connector 430.

As described above, the electronic component 400 according to an embodiment may provide a structure capable of preventing separation of the second connector 430 by the first coupling surface 442 and the second coupling surface 444 inclined with respect to the other surface 422b of the second region 422.

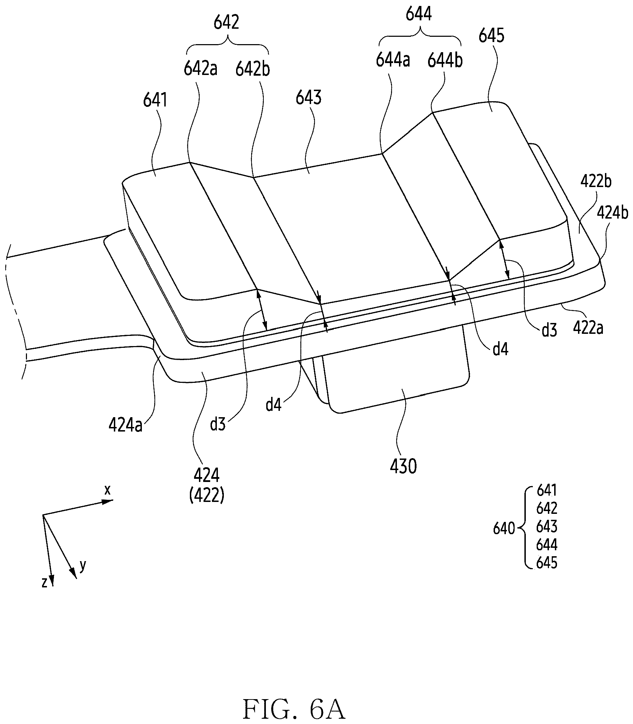

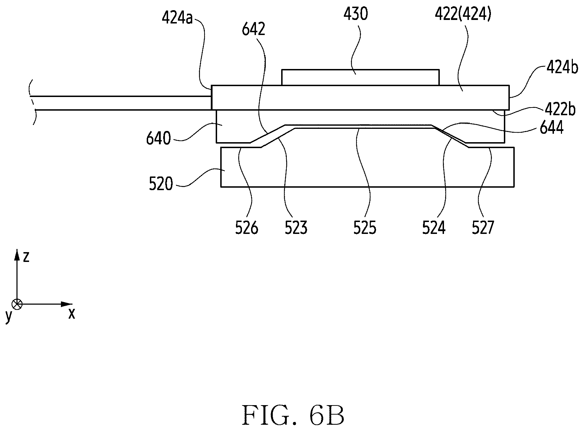

FIG. 6A is a rear view of a second region of an electronic component according to an embodiment, and FIG. 6B is a cross-sectional view of a second region and a supporting portion of an electronic component according to an embodiment.

Referring to FIGS. 6A and 6B, an electronic device (e.g., the electronic device 300 of FIG. 3A) according to an embodiment may include a supporting portion 520 and a stiffening member 640. The supporting portion 520 and the stiffening member 640 of FIGS. 6A and/or 6B may be substantially the same as the supporting portion 320 and the stiffening member 440 of FIGS. 4A, 4B, and/or 4C, respectively, overlapping descriptions will be omitted.

According to an embodiment, the stiffening member 640 may include a first contacting surface 641, a first coupling surface 642, a connecting surface 643, a second coupling surface 644, and/or a second contacting surface 645. The first contacting surface 641, the first coupling surface 642, the connecting surface 643, the second coupling surface 644, and/or the second contacting surface 645 of FIGS. 6A and 6B may be substantially the same as the first contacting surface 441, the first coupling surface 442, the connecting surface 443, the second coupling surface 444, and/or the second contacting surface 445 of FIGS. 4A, 4B, and/or 4C, respectively, overlapping descriptions will be omitted.

According to an embodiment, the first coupling surface 642 may be inclined with respect to another surface 422b of the second region 422. For example, one end 642a of the first coupling surface 642 may be spaced apart from the other surface 422b of the second region 422 by a third distance d3. The one end 642a of the first coupling surface 642 may be connected to the first contacting surface 641 and may mean a part of the first coupling surface 642 facing a first periphery 424a of a rigid region 424. According to an embodiment, another end 642b of the first coupling surface 642 facing the one end 642a of the first coupling surface 642 may be spaced apart from the other surface 422b of the second region 422 by a fourth distance d4 distinct from the third distance d3. The other end 642b of the first coupling surface 642 may be connected to the connecting surface 643 and may mean another part of the first coupling surface 642 facing a second periphery 424b of the rigid region 424.

According to an embodiment, the first coupling surface 642 may extend from the one end 642a of the first coupling surface 642 to the other end 642b of the first coupling surface 642 in a direction getting closer to the other surface 422b of the second region 422. As the first coupling surface 642 extends in a direction closer to the other surface 422b of the second region 422, the third distance d3 between the one end 642a of the first coupling surface 642 and the other surface 422b of the second region 422 may be longer than the fourth distance d4 between the other end 642b of the first coupling surface 642 and the other surface 422b of the second region 422.

According to an embodiment, the second coupling surface 644 may be inclined with respect to the other surface 422b of the second region 422. According to an embodiment, one end 644a of the second coupling surface 644 may be spaced apart from the other surface 422b of the second region 422 by the fourth distance d4. The one end 644a of the second coupling surface 644 may be connected to the connecting surface 643 and may mean a part of the second coupling surface 644 facing the first periphery 424a of the rigid region 424. The one end 644a of the second coupling surface 644 may be spaced apart from the other end 642b of the first coupling surface 642. According to an embodiment, the other end 644b of the second coupling surface 644 facing the one end 644a of the second coupling surface 644 may be spaced apart from the other surface 422b of the second region 422 by the third distance d3. The other end 644b of the second coupling surface 644 may be connected to the second contacting surface 645 and may mean another part of the second coupling surface 644 facing the second periphery 424b of the rigid region 424.

According to an embodiment, the second coupling surface 644 may extend from the one end 644a of the second coupling surface 644 to the other end 644b of the second coupling surface 644, in a direction away from the other surface 422b of the second region 422. As the second coupling surface 644 extends away from the other surface 422b of the second region 422, the fourth distance d4 between the one end 644a of the second coupling surface 644 and the other surface 422b of the second region 422 may be shorter than the third distance d3 which is the distance between the other end 644b of the second coupling surface 644 and the other surface 422b of the second region 422.

According to an embodiment, the first coupling surface 642 and the second coupling surface 644 may be symmetrical to each other. For example, the first coupling surface 642 and the second coupling surface 644 may be symmetrical with respect to the connecting surface 643.

According to an embodiment, the distance between the connecting surface 643 and the other surface 422b of the second region 422 may be shorter than the distance between at least one of the first contacting surface 641 and the second contacting surface 645 and the other surface 422b of the second region 422. For example, the distance between the connecting surface 643 and the other surface 422b of the second region 422 may be the fourth distance d4, and the distance from the first contacting surface 641 and the second contacting surface 645 to the other surface 422b of the second region 422 may be the third distance d3 longer than the fourth distance d4.

According to an embodiment, the supporting portion 520 may include a first seating surface 523, a second seating surface 524, an extending surface 525, a first accommodating surface 526, and a second accommodating surface 527. The first seating surface 523, the second seating surface 524, the extending surface 525, the first accommodating surface 526, and the second accommodating surface 527 of FIGS. 6A and 6B may be substantially the same as the first seating surface 323, the second seating surface 324, the extending surface 325, the first accommodating surface 326, and the second accommodating surface 327 of FIGS. 4A, 4B, and 4C, respectively, overlapping descriptions will be omitted.

According to an embodiment, the first seating surface 523 may face the first coupling surface 642 and may be parallel to the first coupling surface 642. For example, the slope of the first seating surface 523 with respect to the other surface 422b of the second region 422 may be substantially the same as the slope of the first coupling surface 642 with respect to the other surface 422b of the second region 422. According to an embodiment, the distance between the first seating surface 523 and the other surface 422b of the second region 422 may decrease as the first seating surface 523 extends in a direction (e.g., the +x direction) from the first periphery 424a toward the second periphery 424b.

According to an embodiment, the second seating surface 524 may be spaced apart from the first seating surface 523. The second seating surface 524 may face the second coupling surface 644 and may be parallel to the second coupling surface 644. For example, the slope of the second seating surface 524 with respect to the other surface 422b of the second region 422 may be substantially the same as the slope of the second coupling surface 644 with respect to the other surface 422b of the second region 422. According to an embodiment, the distance between the second seating surface 524 and the other surface 422b of the second region 422 may increase as the second seating surface 524 extends in a direction (e.g., the +x direction) from the first periphery 424a toward the second periphery 424b.

According to an embodiment, the distance between the extending surface 525 and the other surface 422b of the second region 422 may be shorter than the distance between at least one of the first accommodating surface 526 and the second accommodating surface 527 and the other surface 422b of the second region 422. For example, the distance between the extending surface 525 and the other surface 422b of the second region 422 may be shorter than the distance between the first accommodating surface 526 and the other surface 422b of the second region 422. For another example, the distance between the extending surface 525 and the other surface 422b of the second region 422 may be shorter than the distance between the second accommodating surface 527 and the other surface 422b of the second region 422. According to an embodiment, the distance between the first accommodating surface 526 and the other surface 422b of the second region 422 may be substantially the same as the distance between the second accommodating surface 527 and the other surface 422b of the second region 422.

According to an embodiment, at least one of the first coupling surface 642 and the second coupling surface 644 may be inclined with respect to a direction (e.g., the -z direction or the +z direction) in which a first connector (e.g., the first connector 331 of FIG. 3A) and a second connector 430 are coupled. When coupling the first connector 331 and the second connector 430, the second region 422 may receive an external force in a direction (e.g., in the -x direction or the +x direction) perpendicular to a coupling direction of the first connector 331 and the second connector 430. For example, when the second region 422 receives an external force in a direction (e.g., the -x direction) perpendicular to the coupling direction of the first connector 331 and the second connector 430, the second coupling surface 644 may slide with respect to the second seating surface 524 by the external force. The second connector 430 may move in the coupling direction (e.g., the +z direction) of the second connector 430 by the movement of the second coupling surface 644. For another example, when the second region 422 receives the external force in a direction (e.g., the +x direction) perpendicular to the coupling direction of the first connector 331 and the second connector 430, the first coupling surface 642 may slide with respect to the first seating surface 523 by the external force. The second connector 430 may move in the coupling direction (e.g., the +z direction) of the second connector 430 by the movement of the first coupling surface 642. As the second connector 430 moves in the coupling direction of the second connector 430, separation between the second connector 430 and the first connector 331 may be prevented.

As described above, the electronic component 400 and the electronic device 300 including the same according to an embodiment may provide a structure capable of preventing separation of the first connector 331 and the second connector 430 by the first coupling surface 642 and the second coupling surface 644 inclined with respect to the other surface 422b of the second region 422.

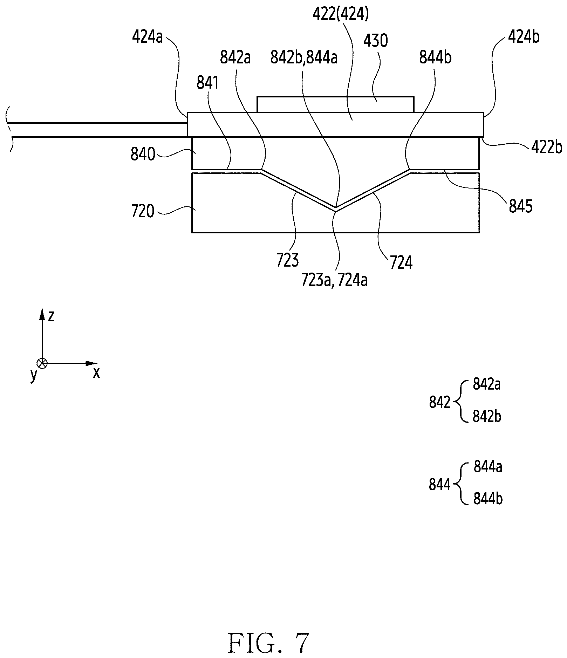

FIG. 7 is a cross-sectional view of a second region and a supporting portion of an electronic component according to an embodiment.

Referring to FIG. 7, an electronic device (e.g., the electronic device 300 of FIG. 3A) according to an embodiment may include a supporting portion 720 and a stiffening member 840. The supporting portion 720 and the stiffening member 840 of FIG. 7 may be substantially the same as the supporting portion 320 and the stiffening member 440 of FIGS. 4A, 4B, and/or 4C, respectively, overlapping descriptions will be omitted.

According to an embodiment, the stiffening member 840 may include a first contacting surface 841, a first coupling surface 842, a second coupling surface 844, and/or a second contacting surface 845. The first contacting surface 841, the first coupling surface 842, the second coupling surface 844, and/or the second contacting surface 845 of FIG. 7 may be substantially the same as a first contacting surface 441, a first coupling surface 442, a second coupling surface 444, and/or a second contacting surface 445 of FIGS. 4A, 4B, and/or 4C, respectively, overlapping descriptions will be omitted.

According to an embodiment, the first coupling surface 842 may be inclined with respect to another surface 422b of the second region 422. One end 842a of the first coupling surface 842 facing the first periphery 424a may be connected to the first contacting surface 841. The first contacting surface 841 may be connected to the one end 842a of the first coupling surface 842 and may be parallel to the other surface 422b of the second region 422. The first contacting surface 841 may be in contact with one end 842a of the first coupling surface 842. The other end 842b of the first coupling surface 842 facing the second periphery 424b may be in contact with the second coupling surface 844.

According to an embodiment, the second coupling surface 844 may be inclined with respect to the other surface 422b of the second region 422. The one end 844a of the second coupling surface 844 facing the first periphery 424a may be connected to the other end 842b of the first coupling surface 842. Another end 844b of the second coupling surface 844 facing the second periphery 424b may be connected to the second contacting surface 845. The second contacting surface 845 may be connected to the other end 844b of the second coupling surface 844 and may be parallel to the other surface 422b of the second region 422.

According to an embodiment, the supporting portion 720 may include a first seating surface 723 and a second seating surface 724. The first seating surface 723 and the second seating surface 724 of FIG. 7 may be substantially the same as the first seating surface 323 and the second seating surface 324 of FIGS. 4A, 4B, and 4C, respectively, overlapping descriptions will be omitted.

According to an embodiment, the first seating surface 723 and the second seating surface 724 may be in contact with each other. For example, one end 723a of the first seating surface 723 facing the second periphery 424b of a rigid region 424 may be in contact with one end 724a of the second seating surface 724 facing the first periphery 424a of the rigid region 424.

As described above, the electronic device (e.g., the electronic device 300 of FIG. 3A) according to an embodiment may provide a structure capable of preventing separation of the second connector 430 by the first coupling surface 842 and the second coupling surface 844 which are inclined with respect to the other surface 422b of the second region 422 and are in contact with each other.

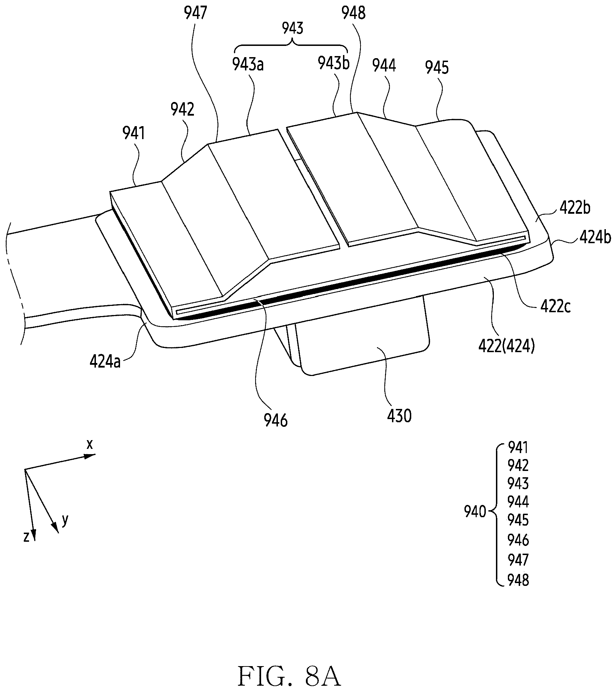

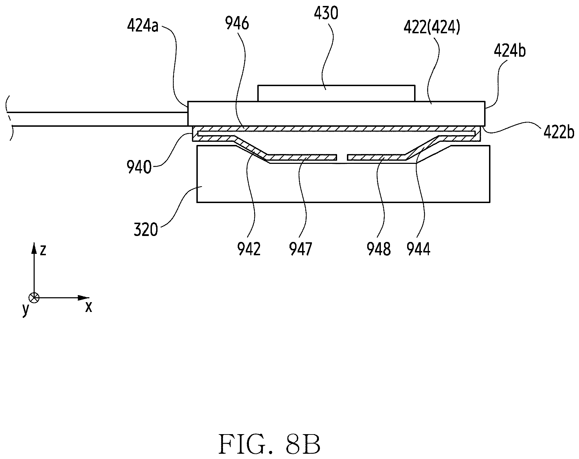

FIG. 8A is a rear view of a second region and a supporting portion of an electronic component according to an embodiment, and FIG. 8B is a cross-sectional view of a second region and a supporting portion of an electronic component according to an embodiment.

Referring to FIGS. 8A and 8B, an electronic device (e.g., the electronic device 300 of FIG. 3A) according to an embodiment may include a stiffening member 940. The stiffening member 940 of FIGS. 8A and/or 8B may be substantially the same as the stiffening member 440 of FIGS. 4A, 4B, and/or 4C, respectively, overlapping descriptions will be omitted.

According to an embodiment, the stiffening member 940 may include a first contacting surface 941, a first coupling surface 942, a connecting surface 943, a second coupling surface 944, a second contacting surface 945, a supporting plate 946, a first connecting plate 947, and/or a second connecting plate 948. The first contacting surface 941, the first coupling surface 942, the connecting surface 943, the second coupling surface 944, and/or the second contacting surface 945 of FIGS. 8A and 8B may be substantially the same as the first contacting surface 441, the first coupling surface 442, the connecting surface 443, the second coupling surface 444, and/or the second contacting surface 445 of FIGS. 4A, 4B, and/or 4C, respectively, overlapping descriptions will be omitted.

According to an embodiment, the second region 422 may include a ground layer 422c in which at least a part thereof is exposed to another surface 422b of the second region 422. The ground layer 422c may be a part of the ground of a second printed circuit board (e.g., the second printed circuit board 420 of FIG. 3A) exposed to the outside of the second region 422. According to an embodiment, the ground layer 422c may be in contact with the stiffening member 940. For example, in case that the stiffening member 940 includes a conductive material such as steel use stainless (SUS), the ground layer 422c in contact with the stiffening member 940 may be electrically connected to the conductive material of the stiffening member 940. The electronic component 400 may have excellent electromagnetic interference (EMI) characteristics and/or electromagnetic susceptibility (EMS) characteristics by the stiffening member 940 including the conductive material electrically connected to the ground layer 422c.

The supporting plate 946 may be disposed on the other surface 422b of the second region 422. According to an embodiment, the supporting plate 946 may be parallel to the other surface 422b of the second region 422. According to an embodiment, the supporting plate 946 may be spaced apart from the first contacting surface 941, the first coupling surface 942, the connecting surface 943, the second coupling surface 944, and the second contacting surface 945.

The first connecting plate 947 may be connected to the supporting plate 946. For example, the first connecting plate 947 may be connected to a part of the supporting plate 946 facing the first periphery 424a of a rigid region 424. According to an embodiment, the first connecting plate 947 may form the first contacting surface 941, the first coupling surface 942, and a part 943a of the connecting surface 943. The first contacting surface 941, the first coupling surface 942, and a part 943 a of the connecting surface 943 may be disposed on the first connecting plate 947 to form an outer surface of the first connecting plate 947. According to an embodiment, the first connecting plate 947 may be deformable. For example, the first connecting plate 947 may be deformed in a direction getting closer to the supporting plate 946 or in a direction away from the supporting plate 946 by an external force.

The second connecting plate 948 may be connected to the supporting plate 946. For example, the second connecting plate 948 may be connected to another part of the supporting plate 946 facing the second periphery 424b of the rigid region 424. According to an embodiment, the second connecting plate 948 may be spaced apart from the first connecting plate 947. According to an embodiment, the second connecting plate 948 may form the second contacting surface 945, the second coupling surface 944, and another part 943b of the connecting surface 943. The second contacting surface 945, the second coupling surface 944, and the other part 943b of the connecting surface 943 may be disposed on the second connecting plate 948 to form an outer surface of the second connecting plate 948. The other part 943b of the connecting surface 943 may be spaced apart from the part 943a of the connecting surface 943, and may face the part 943a of the connecting surface 943. According to an embodiment, the second connecting plate 948 may be deformable. For example, the second connecting plate 948 may be deformed in a direction getting close to the supporting plate 946 or in a direction away from the supporting plate 946 by the external force.

According to an embodiment, at least one of the first connecting plate 947 and the second connecting plate 948 may be deformable when coupling the first connector (e.g., the first connector 331 of FIG. 3A) and the second connector 430. For example, when coupling the first connector 331 and the second connector 430, the second region 422 may receive the external force in a direction (e.g., in the -x direction or the +x direction) perpendicular to the coupling direction of the first connector 331 and the second connector 430. For example, when the second region 422 receives the external force in a direction (e.g., the -x direction) perpendicular to the coupling direction of the first connector 331 and the second connector 430, the first coupling surface 942 may slide with respect to the supporting portion 320 while contacting the supporting portion 320. As the first coupling surface 942 contacts the supporting portion 320, the first connecting plate 947 may be deformed in a direction closer to the supporting plate 946. The first connecting plate 947 may be restored in a direction away from the supporting plate 946 by a restoring force to move the second connector 430 in the coupling direction (e.g., the +z direction) of the second connector 430. For another example, when the second region 422 receives the external force in a direction (e.g., the +x direction) perpendicular to the coupling direction of the first connector 331 and the second connector 430, the second coupling surface 944 may slide with respect to the supporting portion 320 while contacting the supporting portion 320. As the second coupling surface 944 contacts the supporting portion 320, the second connecting plate 948 may be deformed in a direction closer to the supporting plate 946. The second connecting plate 948 may be restored in a direction away from the supporting plate 946 by a restoring force to move the second connector 430 in the coupling direction (e.g., the +z direction) of the second connector 430. As the second connector 430 moves in the coupling direction of the second connector 430, separation between the second connector 430 and the first connector 331 may be prevented.

As described above, the electronic component 400 according to an embodiment may provide a structure capable of preventing separation of the first connector 331 and the second connector 430 by the deformable first connecting plate 947 and the second connecting plate 948 when the electronic component 400 is assembled.

According to an embodiment, an electronic device (e.g., the electronic device 400 of FIGS. 3A and 3B) may include a printed circuit board (e.g., the first printed circuit board 330 of FIGS. 3A and 3B) According to an embodiment, an electronic device may include a first connector (e.g., the first connector 331 of FIGS. 3A and 3B) attached on one surface of the printed circuit board. According to an embodiment, an electronic device may include a flexible printed circuit board (e.g., the second region 422 of FIGS. 4A, 4B, and 4C) including a first surface (e.g., the first surface 422a of FIGS. 4A, 4B, and 4C) facing the one surface of the printed circuit board and a second surface (e.g., the second surface 422b of FIGS. 4A, 4B, and 4C) opposite to the first surface. According to an embodiment, the electronic device may include a second connector (e.g., the second connector 430 of FIGS. 4A, 4B, and 4C) attached to the first surface and aligned with the first connector for electrical connection between the printed circuit board and the flexible printed circuit board. According to an embodiment, the electronic device may include a stiffening member (e.g., the stiffening member 440 of FIGS. 4A, 4B, and 4C) attached to the second surface and arranged with respect to the second connector. According to an embodiment, the electronic device may include a supporting portion (e.g., the supporting portion 320 of FIGS. 4A, and 4C) corresponding to the stiffening member. According to an embodiment, the stiffening member includes a first coupling surface (e.g., the first coupling surface 442 of FIGS. 4B, and 4C) inclined with respect to the first surface to which the second connector aligned with the first connector is attached. According to an embodiment, the supporting portion includes a first seating surface (e.g., the first seating surface 323 of FIGS. 4C) parallel to the first coupling surface and facing the first coupling surface for the alignment of the first connector and the second connector.

According to an embodiment, an electronic device(e.g., the electronic device 400 of FIGS. 3A and 3B) may include a first printed circuit board. a first connector disposed on one surface of the first printed circuit board(e.g., the first printed circuit board 330 of FIGS. 3A and 3B). According to an embodiment, the electronic device may include a second printed circuit board(e.g., the second region 422 or the second printed circuit board 420 of FIGS. 4A, 4B, and 4C) including one surface(e.g., one surface 422a of FIGS. 4A, 4B, and 4C) of the second printed circuit board facing the one surface of the first printed circuit board, and the other surface(e.g., the other surface 422b of FIGS. 4A, 4B, and 4C) of the second printed circuit board. According to an embodiment, the electronic device may include a second connector(e.g., the second connector 430 of FIGS. 4A, 4B, and 4C) disposed on the one surface of the second printed circuit board. According to an embodiment, the electronic device may include a stiffening member(e.g., the stiffening member 440 of FIGS. 4A, 4B, and 4C) including a first coupling surface(e.g., the first coupling surface 442 of FIGS. 4B, and 4C) and disposed on the other surface of the second printed circuit board. According to an embodiment, the electronic device may include a supporting portion(e.g., the supporting portion 320 of FIGS. 4A, and 4C) including a first seating surface(e.g., the first seating surface 323 of FIGS. 4C) in contact with at least part of the first coupling surface and arranged to support the stiffening member. According to an embodiment, the first coupling surface and the first seating surface respectively have a shape to guide the movement of the stiffening member with respect to the support portion so that the second connector moves toward the first connector, when the stiffening member moves in a direction parallel to the other surface of the second printed circuit board.

According to an embodiment, the first coupling surface has a slope with respect to the other surface of the second printed circuit board. According to an embodiment, the first seating surface is parallel to the first coupling surface.

According to an embodiment, at least a part of the first coupling surface and the first seating surface is overlapped to the second connector, when the second circuit board is viewed from a direction the other surface of the second printed circuit board faces.

According to an embodiment, the first coupling surface and the first seating surface is inclined with respect to a coupling direction of the first connector and the second connector perpendicular to the other surface of the second printed circuit board.

According to an embodiment, the first coupling surface has a slope with respect to the other surface of the second printed circuit board, According to an embodiment, the stiffening member further includes a second coupling surface (e.g., the second coupling surface 444 of FIGS. 4B, and 4C) having a slope with respect to the other surface of the second printed circuit board and the first coupling surface. According to an embodiment, one end (e.g., the one end 442a of FIGS. 4B and 4C) of the first coupling surface is spaced apart from the other surface of the second printed circuit board by a first distance, and the other end (e.g., the other end 442b of FIGS. 4B and 4C) of the first coupling surface is spaced apart from the other surface of the second printed circuit board by a second distance different from the first distance. According to an embodiment, one end (e.g., the one end 444a of FIGS. 4B and 4C) of the second coupling surface is close to the other end (e.g., the other end 444b of FIGS. 4B and 4C)of the first coupling surface among the one end of the first coupling surface and the other end of the first coupling surface, the one end of the second coupling surface is spaced apart from the other surface of the second printed circuit board by the second distance, and the other end of the second coupling surface is spaced apart from the other surface of the second printed circuit board by the first distance.

According to an embodiment, the first distance is smaller than the second distance.

According to an embodiment, the first distance is bigger than the second distance.

According to an embodiment, the first coupling surface has a slope with respect to the other surface of the second printed circuit board. According to an embodiment, the stiffening member further include a second coupling surface (e.g., the second coupling surface 444 of FIGS. 4B, and 4C) spaced apart from the first coupling surface and having a slope with respect to the other surface of the second printed circuit board and the first coupling surface. According to an embodiment, the stiffening member further include a first contacting surface (e.g., the first contacting surface 441 of FIGS. 4B, and 4C) connected to one end of the first coupling surface and parallel to the other surface of the second printed circuit board. According to an embodiment, the stiffening member further include a second contacting surface (e.g., the second contacting surface 445 of FIGS. 4B, and 4C) connected to one end of the second coupling surface and parallel to the other surface of the second printed circuit board. According to an embodiment, the stiffening member further include a connecting surface (e.g., the connecting surface 441 of FIGS. 4B, and 4C) disposed between the first coupling surface and the second coupling surface and parallel to the other surface of the second printed circuit board.

According to an embodiment, a distance between the connecting surface and the other surface of the second printed circuit board is longer than a distanced between the other surface of the second printed circuit board and at least one of the first contacting surface and the second contacting surface.

According to an embodiment, a distance between the connecting surface and the other surface of the second printed circuit board is smaller than a distanced between the other surface of the second printed circuit board and at least one of the first contacting surface and the second contacting surface.

According to an embodiment, the first coupling surface has a slope with respect to the other surface of the second printed circuit board. According to an embodiment, the stiffening member further includes a second coupling surface (e.g., the second coupling surface 444 of FIGS. 4B, and 4C) having a slope with respect to the other surface of the second printed circuit board and the first coupling surface. According to an embodiment wherein the supporting portion further includes a second seating surface (e.g., the second seating surface 324 of FIGS. 4C) facing the second coupling surface, parallel to the second coupling surface and spaced apart from the first seating surface. According to an embodiment wherein the supporting portion further includes a first accommodating surface (e.g., the first accommodating surface 326 of FIGS. 4C) parallel to the other surface of the second printed circuit board and connected to one end of the first seating surface. According to an embodiment wherein the supporting portion further includes a second accommodating surface (e.g., the second accommodating surface 327 of FIGS. 4C) parallel to the other surface of the second printed circuit board and connected to one end of the second seating surface. According to an embodiment wherein the supporting portion further includes an extending surface (e.g., the extending surface 325 of FIGS. 4C) parallel to the other surface of the second printed circuit board and disposed between the first seating surface and the second seating surface.

According to an embodiment, a distance between the other surface of the second printed circuit board and the extending surface is bigger than a distance between the other surface of the second printed circuit board and at least one of the first accommodating surface and the second accommodating surface.

According to an embodiment, a distance between the other surface of the second printed circuit board and the extending surface is smaller than a distance between the other surface of the second printed circuit board and at least one of the first accommodating surface and the second accommodating surface.

According to an embodiment, the first coupling surface has a slope with respect to the other surface of the second printed circuit board. According to an embodiment, the stiffening member further includes a second coupling surface having a slope with respect to the other surface of the second printed circuit board and the first coupling surface. According to an embodiment, one end (e.g., the one end 724a of FIGS. 7) of the second coupling surface is in contact with one end (e.g., the one end 723a of FIGS. 7) of the first coupling surface.

According to an embodiment, the stiffening member further includes a first contacting surface (e.g., the first contacting surface 841 of FIGS. 7) parallel to the other surface of the second printed circuit board and connected to the other end of the first coupling surface. According to an embodiment, the stiffening member further includes a second contacting surface (e.g., the second contacting surface 845 of FIGS. 7) parallel to the other surface of the second printed circuit board and connected to the other end of the second coupling surface.

According to an embodiment, the electronic device further includes a camera module (e.g., the camera module 400 of FIGS. 4a) connected to the second printed circuit board. According to an embodiment, the second connector electrically connects the first printed circuit board and the camera module by being coupled to the first connector.

According to an embodiment, an electronic device (e.g., the electronic device 400 of FIGS. 3A and 3B) may include a printed circuit board (e.g., the first printed circuit board 330 of FIGS. 3A and 3B) including a first connector (e.g., the first connector 331 of FIGS. 3A and 3B). According to an embodiment, the electronic device may include a flexible printed circuit board (e.g., the second region 422 of FIGS. 4A, 4B, and 4C) including a first surface (e.g., the first surface 422a of FIGS. 4A, 4B, and 4C), a second surface (e.g., the second surface 422b of FIGS. 4A, 4B, and 4C) opposite to the first surface, and a second connector (e.g., the second connector 430 of FIGS. 4A, 4B, and 4C) disposed to the first surface, and the flexible printed circuit board electrically connected to the printed circuit board through the second connector coupled to the first connector. According to an embodiment, the electronic device may include a stiffening member (e.g., the stiffening member 440 of FIGS. 4A, 4B, and 4C) disposed to the second surface. According to an embodiment, the electronic device may include a supporting portion (e.g., the supporting portion 320 of FIGS. 4A, and 4C) facing the stiffening member, and having a shape corresponding to the stiffening member, configured to inhibit the first connector and the second connector from being separated each other. According to an embodiment, the stiffening member including a first coupling surface (e.g., the first coupling surface 442 of FIGS. 4B, and 4C) and the second coupling surfaced (e.g., the second coupling surface 444 of FIGS. 4B, and 4C) inclined with respect to the second surface respectively. According to an embodiment, the first coupling surface and the second coupling surface inclined with respect to a direction in which the second surface faces. According to an embodiment, the supporting portion includes a first seating surface (e.g., the first seating surface 323 of FIGS. 4C) parallel to the first coupling surface and facing the first coupling surface, and a second seating surface (e.g., the second seating surface 325 of FIGS. 4C) parallel to the second coupling surface and facing the second coupling surface.

According to an embodiment, at least one of the first coupling surface and the first seating surface is inclined with respect to a coupling direction of the first connector and the second connector parallel to a direction from the second surface toward the first surface.

According to an embodiment, at least a part of the first coupling surface and the first seating surface is overlapped to the second connector, when the flexible printed circuit board is viewed from above.

According to an embodiment, wherein the second coupling surface is spaced apart from the first coupling surface. According to an embodiment, the stiffening member further includes a first contacting surface (e.g., the first contacting surface 441 of FIGS. 4B) parallel to the second surface and connected to one end of the first coupling surface. According to an embodiment, the stiffening member further includes a second contacting surface (e.g., the second contacting surface 441 of FIGS. 4B) parallel to the second surface and connected to one end of the second coupling surface. According to an embodiment, the stiffening member further includes a connecting surface (e.g., the connecting surface 441 of FIGS. 4B) parallel to the second surface and disposed between the first coupling surface and the second coupling surface.

According to an embodiment, wherein the second seating surface is spaced apart from the first seating surface. According to an embodiment, the supporting portion further includes a first accommodating surface (e.g., the first accommodating surface 326 of FIGS. 4C) parallel to the second surface and connected to one end of the first seating surface. According to an embodiment, the supporting portion further includes a second accommodating surface (e.g., the second accommodating surface 327 of FIGS. 4C) parallel to the second surface and connected to one end of the second seating surface. According to an embodiment, the supporting portion further includes an extending surface (e.g., the extending surface 325 of FIGS. 4C) parallel to the second surface and disposed between the first seating surface and the second seating surface.

An electronic device comprising, a first circuit board (e.g. a first printed circuit board) having a first surface (or first side), a first connector disposed on (or mounted on, or attached to) the first surface of the first circuit board, a second circuit board (e.g. a second printed circuit board, and/or which in certain embodiments is a flexible circuit board, e.g. a circuit board comprising at least a flexible portion) having a first surface (or first side) facing (i.e. facing towards) the first surface of the first circuit board, and a second surface (or second side) opposite the first surface of the second circuit board (e.g. the second surface facing away from the first surface of the first circuit board); a second connector disposed on (or mounted on, or attached to) the first surface of the second circuit board, the second connector being in (or located in, or arranged in) a connected position in which it is connected to the first connector to provide electrical connection between the first and second circuit boards, the electronic device further comprising a first member (e.g. a stiffening member) disposed on (or mounted on, or attached to) the second surface of the second circuit board and having a first coupling surface; and a support having a first seating surface, the support being adapted to seat the first member in a seated position in which at least a first portion of the first coupling surface is in contact with (or engages,) at least a first portion of the first seating surface and the second connector is supported in the connected position (i.e. is supported by the first member, e.g. indirectly, via the second circuit board).

The first portion of the first coupling surface and the first portion of the first seating surface are arranged such that a force applied to the first member in a direction parallel to the second surface of the second circuit board, when the first member is in the seated position, results in a force (i.e. a reactive force) urging the second connector towards the first connector (e.g. a force in a direction normal or perpendicular to the second surface of the second circuit board).

The support is arranged to receive and engage the first member (e.g. in a first engagement position, in which at least a portion of the first coupling surface is in contact with at least a portion of the first seating surface) as the electronic device is assembled and guide the first member into the seated position (e.g. the support may provide guide means, and/or the first seating surface may comprise a slide surface along which the first member may slide from a first engagement position to the seated position).

At least one of the first portions of the first coupling surface and the first seating surface is inclined (and optionally planar) with respect to the second surface of the second circuit board (e.g. both may be inclined).

At least one of the first portions of the first coupling surface and the first seating surface is curved (e.g. one may be convex, the other flat, inclined, or concave; or one may be concave, the other flat, inclined, or convex).

The first coupling surface and the first seating surface further comprise respective second portions arranged in contact with one another when the first member is in the seated position, wherein at least one of the second portions of the first coupling surface and the first seating surface is inclined (and optionally planar) with respect to the second surface of the second circuit board (e.g. both may be inclined). At least one of the second portions of the first coupling surface and the first seating surface is curved (e.g. one may be convex, the other flat, inclined, or concave; or one may be concave, the other flat, inclined, or convex). first coupling surface and the first seating surface further comprise respective third portions arranged in contact with one another when the first member is in the seated position. Each of the third portions is flat (e.g. planar, and/or parallel to the second surface of the second circuit board). The support is a support member (e.g. attached to a housing of the electronic device) or an integral part of a housing of the electronic device. The second circuit board comprises at least a flexible portion.

The first surface of the second circuit board is a surface on one side of the flexible portion and the second surface of the second circuit board is a surface of an opposite side of the flexible portion.

The first member is arranged to stiffen the flexible portion.

The first member is a aligned with the second connector to support the second connector in the seated position.

The first member comprises at least one resilient portion (e.g. adapted to urge the second connector towards the first connector, or bias the connectors in the connected position, when the first member is in the seated position).

It will be appreciated that the above-described embodiments, and their technical features, may be combined with one another in each and every combination, potentially unless there is a conflict between two embodiments or features. That is, each and every combination of two or more of the above-described embodiments is envisaged and included within the present disclosure. One or more features from any embodiment may be incorporated in any other embodiment, and provide a corresponding advantage or advantages.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a first printed circuit board;
a first connector disposed on one surface of the first printed circuit board;
a second printed circuit board including one surface of the second printed circuit board facing the one surface of the first printed circuit board, and the other surface of the second printed circuit board;
a second connector disposed on the one surface of the second printed circuit board;
a stiffening member including a first coupling surface and disposed on the other surface of the second printed circuit board;
a supporting portion including a first seating surface in contact with at least part of the first coupling surface, and arranged to support the stiffening member; and
wherein the first coupling surface and the first seating surface respectively have a shape to guide the movement of the stiffening member with respect to the support portion so that the second connector moves toward the first connector, when the stiffening member moves in a direction parallel to the other surface of the second printed circuit board.

2. The electronic device of claim 1,
wherein the first coupling surface has a slope with respect to the other surface of the second printed circuit board,
wherein the first seating surface is parallel to the first coupling surface.

3. The electronic device of any one of claims 1 and 2,
wherein at least a part of the first coupling surface and at least a part of the first seating surface are overlapped by at least a part of the second connector, when the second circuit board is viewed from a direction the other surface of the second printed circuit board faces.

4. The electronic device of any one of claims 1 to 3,
wherein the first coupling surface has a slope with respect to the other surface of the second printed circuit board,
wherein the stiffening member further includes a second coupling surface having a slope with respect to the one surface of the second printed circuit board and the first coupling surface,
wherein one end of the first coupling surface is spaced apart from the other surface of the second printed circuit board by a first distance,
wherein the other end of the first coupling surface is spaced apart from the other surface of the second printed circuit board by a second distance different from the first distance,
wherein one end of the second coupling surface is close to the other end of the first coupling surface among the one end of the first coupling surface and the other end of the first coupling surface, the one end of the second coupling surface is spaced apart from the other surface of the second printed circuit board by the second distance, and
wherein the other end of the second coupling surface is spaced apart from the other surface of the second printed circuit board by the first distance.

5. The electronic device of claim 4,
wherein the first distance is smaller than the second distance.

6. The electronic device of claim 4,
wherein the first distance is bigger than the second distance.

7. The electronic device of any one of claims 1 to 3,
wherein the first coupling surface has a slope with respect to the other surface of the second printed circuit board,
wherein the stiffening member further includes:
a second coupling surface spaced apart from the first coupling surface and having a slope with respect to the one surface of the second printed circuit board and the first coupling surface;
a first contacting surface connected to one end of the first coupling surface and parallel to the second surface;
a second contacting surface connected to one end of the second coupling surface and parallel to the second surface; and
a connecting surface disposed between the first coupling surface and the second coupling surface and parallel to the second surface.

8. The electronic device of claim 7,
wherein a distance between the connecting surface and the other surface of the second printed circuit board is longer than a distanced between the other surface of the second printed circuit board and at least one of the first contacting surface and the second contacting surface.

9. The electronic device of claim 7,
wherein a distance between the connecting surface and the other surface of the second printed circuit board is smaller than a distanced between the other surface of the second printed circuit board and at least one of the first contacting surface and the second contacting surface.

10. The electronic device of any one of claims 1 to 3 and 7 to 9,
wherein the first coupling surface has a slope with respect to the other surface of the second printed circuit board,
wherein the stiffening member further includes a second coupling surface having a slope with respect to the one surface of the second printed circuit board and the first coupling surface;
wherein the supporting portion further includes:
a second seating surface facing the second coupling surface, parallel to the second coupling surface and spaced apart from the first seating surface;
a first accommodating surface parallel to the other surface of the second printed circuit board and connected to one end of the first seating surface;
a second accommodating surface parallel to the other surface of the second printed circuit board and connected to one end of the second seating surface; and
an extending surface parallel to the other surface of the second printed circuit board and disposed between the first seating surface and the second seating surface.

11. The electronic device of claim 10,
wherein a distance between the other surface of the second printed circuit board and the extending surface is bigger than a distance between the other surface of the second printed circuit board and at least one of the first accommodating surface and the second accommodating surface.

12. The electronic device of claim 10,
wherein a distance between the other surface of the second printed circuit board and the extending surface is smaller than a distance between the other surface of the second printed circuit board and at least one of the first accommodating surface and the second accommodating surface.

13. The electronic device of any one of claims 1 to 3,
wherein the first coupling surface has a slope with respect to the other surface of the second printed circuit board,
wherein the stiffening member further includes a second coupling surface having a slope with respect to the one surface of the second printed circuit board and the first coupling surface; and
wherein, one end of the second coupling surface is in contact with one end of the first coupling surface.

14. The electronic device of claim 13,
wherein the stiffening member further includes:
a first contacting surface parallel to the second surface, and connected to the other end of the first coupling surface;
a second contacting surface parallel to the other surface of the second printed circuit board and connected to the other end of the second coupling surface.

15. The electronic device of any preceding claim,
wherein the electronic device further includes a camera module connected to the second printed circuit board; and
wherein the second connector electrically connects the first printed circuit board and the camera module by being coupled to the first connector.
